(19) Europäisches Patentamt / European Patent Office / Office européen des brevets

(11) **EP 1 500 940 B1**

(12) **EUROPÄISCHE PATENTSCHRIFT**

(45) Veröffentlichungstag und Bekanntmachung des Hinweises auf die Patenterteilung:
**05.03.2014 Patentblatt 2014/10**

(51) Int Cl.:
*G01L 9/00* *(2006.01)*       *G01N 27/22* *(2006.01)*
*G01F 23/26* *(2006.01)*

(21) Anmeldenummer: **04007750.5**

(22) Anmeldetag: **31.03.2004**

(54) **Verfahren zum Auswerten einer Messkapazität**

Method for evaluating a capacitor

Procédé pour évaluer un condensateur

(84) Benannte Vertragsstaaten:
**DE FR GB**

(30) Priorität: **22.07.2003 DE 10333154**

(43) Veröffentlichungstag der Anmeldung:
**26.01.2005 Patentblatt 2005/04**

(73) Patentinhaber: **VEGA Grieshaber KG**
**77709 Wolfach (DE)**

(72) Erfinder:
• **Mellert, Martin**
**77790 Steinach (DE)**

• **Fichter, Jürgen**
**77791 Schiltach (DE)**
• **Auber, Herbert**
**78112 St. Georgen (DE)**

(74) Vertreter: **Patentanwälte**
**Westphal, Mussgnug & Partner**
**Am Riettor 5**
**78048 Villingen-Schwenningen (DE)**

(56) Entgegenhaltungen:
**EP-A- 1 411 349       WO-A-01/04648**
**DE-A- 4 222 788       DE-C- 4 340 472**

Printed by Jouve, 75001 PARIS (FR)

## Beschreibung

Die Erfindung betrifft ein Verfahren zum Auswerten einer Messkapazität gemäß dem Oberbegriff des Anspruchs 1 und eine Schaltungsanordnung zur Durchführung dieses Verfahrens.

Ein Verfahren zum Messen einer Kapazität ist beispielsweise aus DE 34 13 849 A1 sowie DE 35 44 187 A1 bekannt. In der erstgenannten Druckschrift ist in Fig. 1 eine Schaltungsanordnung zur Messung einer Kapazität angegeben, bei der die Kapazität mit einem Anschluss dauerhaft auf Bezugspotential gehalten und der andere Anschluss zwischen einer Referenzspannungsquelle und einem Integrator umgeschaltet wird. Die Schaltung enthält eine an eine Betriebsspannung geschaltete Integrationseinrichtung mit einem Operationsverstärker. Die Integrationseinrichtung wird mit der auf der zu messenden Kapazität befindlichen Ladung aufgeladen und anschließend über eine parallel zu einem Integrationskondensator liegende Schalteinrichtung wieder entladen. Die Kenngrößen des Umladevorgangs sind ein Maß für die zu messende Kapazität.

In der zweitgenannten Druckschrift ist eine Kapazitätsmessschaltung beschrieben, die ebenfalls eine Umschaltanordnung aufweist, welche die Messkapazität mit einer vorgegebenen Umschaltfrequenz periodisch abwechselnd zur Aufladung an eine konstante Spannung legt und zur Entladung mit einem Speicherkondensator verbindet, dessen Kapazität groß gegen die Messkapazität ist. Die Klemmenspannung des Speicherkondensators wird durch einen kontrollierten Entladestrom im Wesentlichen auf einem konstanten Bezugspotential gehalten. Im Gegensatz zur erstgenannten Druckschrift ist nicht die auftretende Umladefrequenz ein Maß für die zu messende Kapazität, sondern die Größe des Entladestromes proportional zur Messkapazität.

Ein Verfahren zur Kapazitätsmessung von kapazitiven Sensoren ist darüber hinaus aus der DE 42 37 196 C1 bekannt. Ein Anschluss der zu messenden Kapazität, d. h. des Messkondensators, ist fest mit einem Bezugspotential, vorzugsweise dem Massepotential der Gesamtanordnung verbunden. Ein solches Verbinden des einen Anschlusses der zu messenden Kapazität mit Bezugspotential ist dann von Vorteil, wenn der Sensor unter undefiniert wechselndem Kapazitätsverhältnis zum Beispiel aufgrund unterschiedlicher Oberflächenfeuchte oder elektrischer Störeinkopplungen einzusetzen ist. Hierbei wird die dem Gehäuse bzw. dem zu messenden Medium zugewandte Elektrode des Messkondensators auf konstantem Potential gehalten. Die andere Elektrode des Messkondensators wird dagegen bei der bekannten Schaltungsanordnung mit dem Eingang einer Integrationseinrichtung, die einen Integrationskondensator aufweist, schaltbar verbunden. Die zu messende Kapazität wird dabei zunächst in einer Ladephase durch eine vorbestimmte Potentialdifferenz aufgeladen und die dabei gespeicherte Ladung nachfolgend in einer Entladephase auf den Integrationskondensator der Integrationseinrichtung umgeladen und dort ausgewertet. Dabei ist die zu messende Kapazität sowohl in der Ladephase als auch in der Entladephase mit ihrem nicht auf Bezugspotential liegenden Anschluss mit einem Referenzpotential verbunden, das in der Ladephase auf einen anderen Wert als in der Entladephase gelegt wird. Durch das dabei periodisch wechselnde Betriebsspannungspotential lassen sich messwertverfälschende Kapazitäten der Schaltungsanordnung neutralisieren und somit auch kleine Kapazitätswerte bzw. Kapazitätsveränderungen mit höherer Genauigkeit auswerten.

Problematisch bei diesen bekannten Verfahren ist jedoch das Umschalten des Betriebsspannungspotentiales, das vor allem bei der Realisierung der Schaltungsanordnung als anwendungsspezifische integrierte Schaltung (ASIC = Application Specific Integrated Circuit) in CMOS-Technik zu Schwierigkeiten führen kann, da dort dann unterschiedliche Betriebsspannungspotentiale auf einem einzigen ASIC-Substrat beherrscht werden müssen.

Das Messen einer Kapazität, bei der ein Anschluss fest mit Bezugspotential verbunden ist, zeichnet sich zwar durch eine geringe Empfindlichkeit gegenüber äußeren Störeinflüssen aus, ist jedoch wegen des Miterfassens von parallel zum Messkondensator liegenden parasitären Kapazitäten nachteilig. Solche parasitären Kapazitäten erhöhen nämlich die zu messende Kapazität und schlagen sich in einer Reduzierung der Empfindlichkeit der Messeinrichtung nieder. Zusätzlich sind solche parasitären Kapazitäten weder temperatur- noch langzeitstabil, was ebenfalls zu Beeinträchtigungen des Messergebnisses führt. Schließlich beeinflussen auch parallel zum Messkondensator liegende Widerstände das Messergebnis. Solche Parallelwiderstände treten, wenngleich hochohmig, zum Beispiel aufgrund von durch Luftfeuchtigkeit bedingten Oberflächenüberzügen auf Sensor-Keramiksubstraten auf.

DE 43 40 472 C1 schlägt diesbezüglich ein Verfahren und eine Schaltungsanordnung zur Messung der Kapazität eines Messkondensators, bei dem ein Anschluss fest mit Bezugspotential verbunden ist, vor, bei dem eine Realisierung auf einem einzigen ASIC-Substrat möglich ist und trotzdem die Störeinflüsse aufgrund von Parallelwiderständen reduziert werden. Angegeben wird dazu ein Verfahren zur Messung einer Kapazität, die mit einem ersten Anschluss mit Bezugspotential verbunden ist, unter Verwendung einer an eine Betriebsspannung geschalteten Integrationseinrichtung mit einem Integrationskondensator, der mit einer auf der zu messenden Kapazität befindlichen Ladung aufgeladen und anschließend wieder entladen wird, wobei die dabei auftretende Umladefrequenz ein Maß für die zu messende Kapazität darstellt und wobei das Auf- und Entladen des Integrationskondensators jeweils bis zu einer vorgegebenen Referenzschwelle erfolgt und zu Beginn des Auf- bzw. Entladevorganges durch Ankoppeln der Kapazität (CM) negative bzw. positive Ladungsstöße mit jeweils gleicher Amplitude auf den Integrationskondensator übertragen werden.

Aus der WO 01/04648 A1 ist bekannt, dass die Bestimmung von Kapazitäten und deren Abhängigkeit von Feuchtigkeit mit Hilfe von Ladungstransfermessmethoden möglich ist, die unterschiedliche Ladungs-/Umladungszeiten verwenden, wobei die Messungen mit längeren Ladungs-/Umladungszeiten stärker durch die Feuchtigkeit beeinflusst werden. Es wird vorgeschlagen, durch eine Reihe solcher Messungen die Steigung der gegen die Ladungs-/Umladungszeiten aufgetragenen gemessenen Kapazitätswerte zu bestimmen und die Messung mit der kürzesten Ladungs-/Umladungszeit damit entsprechend zu korrigieren.

Eine weitere Möglichkeit zur Bestimmung der Effekte von Feuchtigkeit mit einem kapazitiven Feuchte-Messelement lehrt die EP 1 411 349 A1, in der ein kapazitives Feuchte-Messelement für Berechnungen durch die Parallelschaltung eines idealen Kondensators und eines Ohmschen Widerstands modelliert wird. Dabei wird durch Laden und/oder Entladen des kapazitiven Feuchte-Messelements über einen ersten Messwiderstand eine erste Zeitkonstante oder eine erste Periodendauer des Lade- und/oder Entladevorgangs ermittelt und durch Laden und/oder Entladen des Feuchte-Messelements über einen zweiten Messwiderstand eine zweite Zeitkonstante oder Periodendauer. Aus den beiden Zeitkonstanten oder den beiden Periodendauern wird dann die Kapazität des Feuchte-Messelements berechnet, aus der schließlich ein Wert für die Feuchte ermittelt wird.

Ausgehend von diesem Stand der Technik stellt sich jedoch das Problem, unter Vermeidung des Durchlaufens vollständiger Lade-/Entladezyklen eine konkrete Messvorschrift anzugeben, bei der die am Messkondensator ablaufenden Lade- bzw. Entladevorgänge möglichst kurz gehalten werden, bei der aber trotzdem eine zuverlässige Abschätzung des störenden Einflusses von Feuchtigkeit oder anderen parallelen Widerständen ermöglicht wird. Insbesondere soll diese Aufgabe gelöst werden, um ein Verfahren zum Auswerten von Messkapazitäten einer Druck-Messeinrichtung zu verbessern, die in einfacher Art und Weise eine Stabilität der Messbedingungen überwachen lassen.

Diese Aufgabe wird durch ein Verfahren zum Auswerten von Messkapazitäten einer Messeinrichtung für Druckmessungen mit den Merkmalen des Patentanspruchs 1 gelöst.

Das bevorzugte Verfahren zum Auswerten einer Messkapazität als Kapazität einer Messeinrichtung weist einen ersten Zyklus von Schritten auf, bei dem die Kapazität über eine erste Ladedauer geladen wird, worunter auch das Aufbringen einer negativen Ladung, d. h. ein Entladen, verstanden wird, woraufhin die Ladung der Kapazität als ein erster Messwert bestimmt wird. Nachfolgend wird der Zyklus mit einer zweiten Ladedauer wiederholt, um einen zweiten Messwert zu bestimmen, woraufhin der erste und der zweite Messwert miteinander verglichen werden, um ein Vergleichsergebnis zu erhalten, welches zum Bestimmen einer Messbedingung dient, welche den Grundzustand der Kapazität verändert haben kann und somit zu einem verfälschten Messergebnis führen kann.

Eine bevorzugte Schaltungsanordnung zum Durchführen eines solchen Verfahrens weist entsprechend eine Messkapazität zum Bestimmen einer Messgröße, eine Lade- und Entlade-Schaltungsanordnung zum Laden bzw. Entladen der Messkapazität von einer Referenzspannung ausgehend, eine Messwert-Bestimmungseinrichtung zum Bestimmen eines Messwerts und eine Auswerteeinrichtung zum Auswerten des Messwerts auf. Dabei sind die einzelnen Schaltungskomponenten zum Bestimmen zweier verschiedener Messwerte durch Anlegen oder Abziehen von Ladungen an die Kapazität mit einer unterschiedlichen Lade- bzw. Entladedauer-ausgebildet. Die einzelnen Komponenten können dabei als separate Schaltungskomponenten oder teilweise oder insgesamt als eine integrierte Schaltung ausgebildet sein.

Vorteilhafte Ausgestaltungen sind Gegenstand abhängiger Ansprüche.

Vorzugsweise erfolgt das Laden bzw. Entladen der Kapazität durch ein Umladen von bzw. zu einer anderen Kapazität, und zwar von einem Referenzspannungswert der anderen Kapazität ausgehend. Vorzugsweise ist die andere Kapazität Teil einer Integratorschaltung, welche nach dem Umladen eine lineare Entladung bzw. Rückladung der anderen Kapazität bis zu dem Referenzspannungswert durchführt. Die Dauer der Entladung bzw. Rückladung wird dabei als der erste bzw. zweite Messwert festgelegt und steht in direktem Verhältnis zu der Messkapazität sowie der Messbedingung, welcher die Messkapazität unterliegt. Aus der Umladedauer, welche neben der Entladung bzw. Rückladung auch die eigentliche Umladung zwischen den beiden Kapazitäten einschließt, bzw. aus einem Umladezyklus kann direkt auf die Messbedingung, insbesondere eine trockene oder feuchte Umgebung der Messkapazität geschlossen werden.

Zweckmäßigerweise werden zur Berücksichtigung von Toleranzen ein Toleranzwert festgesetzt und vorbestimmte Wertebereiche angegeben, welche zum Bestimmen eines Änderungsbetrags der Messbedingung mit dem Vergleichsergebnis verglichen werden.

Die erste und die zweite Ladedauer werden zweckmäßigerweise so festgesetzt, dass bei einer Ladedauer eine vollständige Ladung der Messkapazität bzw. eine vollständige Umladung zwischen Messkapazität und der anderen Kapazität unabhängig von der Messbedingung durchgeführt wird. Unter einer vollständigen Ladung wird dabei auch eine nahezu vollständige Ladung mit Blick darauf verstanden, dass ein Kondensator bei dem Ladevorgang einer zeitlich exponentiellen Funktion unterliegt. Die andere Ladedauer wird so ausgewählt, dass bei veränderten Messbedingungen eine nicht vollständige Ladung bzw. Entladung oder Umladung der Messkapazität erfolgt, so dass aufgrund der entsprechend verschiedenen ersten und zweiten Messwerte auf die momentane Messbedingung geschlossen werden kann.

Zweckmäßigerweise wird das Unter- oder Überschreiten des Vergleichsergebnisses über einen vorbestimmten Grenzwert zur automatischen Ausgabe eines Warnsignals oder automatischen Veranlassung einer Korrektur von Messergebnissen verwendet.

Bevorzugte Einsatzbereiche liegen in dem Bestimmen einer feuchtebedingten Kapazitätsänderung der Messkapazität und/oder in der Bestimmung einer Änderung der Kapazität aufgrund veränderter Innenwiderstände auf der Kapazitäts-Ladestrecke.

Vorzugsweise werden das Verfahren und die Schaltungsanordnung auf Basis eines Verfahrens bzw. einer Schaltungsanordnung mit den für sich bekannten Merkmalen der DE 43 40 472 C1 umgesetzt.

Ein Ausführungsbeispiel wird nachfolgend anhand der Zeichnung näher erläutert. Es zeigen:

Fig. 1        ein Prinzipschaltbild einer Schaltungsanordnung zum Bestimmen einer Messkapazität und zum Bewerten der Messbedingung;

Fig. 2        eine Messkurve des Spannungsverlaufs an einem Integratorausgang sowie eine zeitliche Darstellung von Schaltzuständen verschiedener Schaltungskomponenten für eine erste vorgegebene Umladezeit und bei idealen Messbedingungen;

Fig. 3        eine Messkurve des Spannungsverlaufs am Integratorausgang für eine zweite Umladedauer bei idealen Messbedingungen;

Fig. 4A, 4B   Spannungsverläufe an einem störenden Kondensator, der parallel zum Messkondensator liegt für die erste bzw. zweite Umladedauer;

Fig. 5A, 5B   die entsprechenden Messkurven des Spannungsverlaufs am Integratorausgang; und

Fig. 6        die Messkurven der Fig. 5A, 5B in überlagerter Darstellung mit entsprechenden Zeitstrahlen.

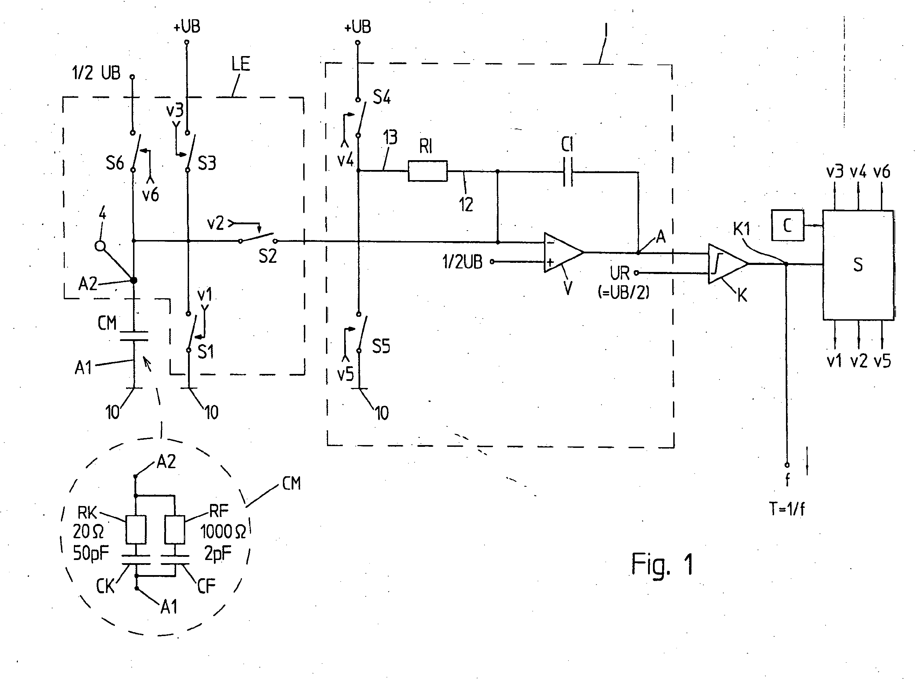

Wie aus Fig. 1 ersichtlich, weist eine Schaltungsanordnung mit einer Messkapazität CM, insbesondere eine Lade- und Entlade-Einrichtung LE, eine damit verbundene Integrator-Schaltung I, einen Komparator K, eine Steuereinrichtung S zum Steuern der Lade- und Entlade-Einrichtung LE und ggf. der Integrator-Schaltung I sowie einen Frequenz-Ausgang f zum Ausgeben einer Frequenz f auf. Die einzelnen Komponenten können dabei ganz oder teilweise als einzelne separate Bauelemente, als auf einer Platine gruppierte Bauelemente oder als integrierter Schaltkreis ausgebildet sein.

Insbesondere dient die Schaltungsanordnung als Füllstand- oder Druckmessgerät mit einer kapazitiven Druckmesszelle als zu messender Kapazität CM. Die Auswertung der kapazitiven Druckmesszelle erfolgt in für sich bekannter Art und Weise, beispielsweise gemäß den Ausführungen der DE 43 40 472 C1

Die Auswertung der Kapazität als der Messkapazität CM bzw. einer Referenzkapazität wird dabei gegenüber bekannten Ausführungen derart modifiziert, dass neben der Erfassung der Messkapazität CM bzw. Referenzkapazität noch eine zusätzliche Bewertung des Messwertes bzw. der Messbedingungen, welche Auswirkungen auf den Messwert haben, erfolgt. Um eine Bewertung des Messwertes durchführen zu können, werden die Messkapazitäten, vorliegend die zu messende Kapazität CM und eine damit koppelbare Integrationskapazität CI mit zwei unterschiedlichen Umladezeiten zum Umladen von Ladungen zwischen diesen erfasst. Sind die Messwerte beider Umladezeiten identisch, so ist der Messwert stabil und zuverlässig. Sind die Messwerte der beiden Umladezeiten innerhalb bestimmter Grenzwerte unterschiedlich, deutet dies auf einen instabilen Messwert hin. Der Messwert kann jedoch als noch gültig ausgegeben werden. Werden die Grenzwerte über- bzw. unterschritten, so ist von zu ungenauen Messwerten auszugehen und ein Fehlersignal auszugeben oder eine automatische Korrektur zu veranlassen. Vorteilhafterweise kann in einer Bedienbetriebsart der Wert der Zuverlässigkeit dargestellt werden, z. B. als Angabe von Prozent der Messunsicherheit.

Eine besonders hervorzuhebende Messbedingung, welche bei Änderung direkten Einfluss auf das Messergebnis bzw. den Messwert hat, ist der Feuchtezustand im Bereich der zu messenden Kapazität. Insbesondere kapazitive relative Druckmesszellen können auf Feuchte empfindlich reagieren. Feuchte bewirkt eine Änderung der effektiven Kapazitätswerte der zu messenden Kapazität CM. Der Einfluss von Feuchte ist anhand der dargestellten Ausschnittsvergrößerung in Fig. 1 veranschaulicht. Zwischen zwei Anschlüssen bzw. Abgriffen A1, A2 ist eine kapazitive Messzelle mit der zu messenden Kapazität CM angeordnet. Wirksam ist dabei bei trockenen Messbedingungen eine Reihenschaltung aus einem kapazitiven Element CK und einem ohmschen Element RK. Kommt Feuchte hinzu, so wirkt diese sich wie eine parallel geschaltete Reihenschaltung aus einem weiteren feuchteabhängigen kapazitiven Element CF und einem feuchteabhängigen ohmschen Element RF aus.

Bei einem beispielhaften Druckmessgerät beträgt bei trockener Messbedingung die Kapazität CK z. B. 50 pF und der innere Widerstand RK 20 $\Omega$. Durch eine feuchte Belüftung der Messzelle kommt zur eigentlichen Messkapazität das weitere parallele RC-Glied hinzu. Die Werte für dieses parallele RC-Glied können z. B. für den inneren Widerstand RF 1000 $\Omega$ und für die kapazitive Wirkung CF 2 pF betragen, wobei diese Werte insbesondere in engen Grenzen variieren können.

Zur Bestimmung des Messwertes der zu messenden Kapazität CM weist die Schaltungsanordnung außerdem einen zusätzlichen bzw. anderen Kondensator auf, der als Integrationskapazität CI Bestandteil eines Integrators I ist. Zwischen diesen beiden Kondensatoren bzw. Kapazitäten CM und CI wird über die Betätigung eines Schalters S2 eine zeitlich befristete Umladung von Ladungen vorgenommen. Zwischen den einzelnen Umladungen ändert sich die Spannung der Integrationskapazität CI, wobei jeweils bei Erreichen einer Referenzspannung UR ein Frequenzsignal f ausgegeben wird. Durch die Variation der Umladezeiten zwischen der zu messenden Kapazität CM und der Integrationskapazität CI ist feststellbar, ob eine feuchteabhängige Komponente vorliegt oder nicht, indem die Messwerte bzw. die Frequenz des Frequenzsignals f betrachtet und auf verschiedene Frequenzwerte untersucht werden.

Die dazu zumindest zwei gewählten Umladezeiten tk1, tk2 werden so ausgewählt, dass bei idealen, insbesondere bei trockenen Bedingungen für beide Umladezeiten tk1, tk2 eine vollständige Aufladung des Messkondensators CM erfolgt. Beide Umladezeiten tk1, tk2 führen zum gleichen Messergebnis bzw. zum gleichen Frequenzwert f.

Außerdem werden die beiden Umladezeiten tk1, tk2 so gewählt, dass für den Fall einer feuchteabhängigen Komponente, welche zu einer veränderten Messbedingung führt, in der kürzeren Umladezeit der Messkondensator CM nicht komplett aufgeladen wird, während bei der längeren Umladezeit die feuchteabhängige Komponente hinsichtlich der Auswirkung auf die Gesamtkapazität CM überwiegend einwirkt und mit in das Ergebnis eingeht.

Bei einer beispielhaften typischen Umladezeit von tk1 = 10 $\mu$s geht die feuchteabhängige Komponente zu 99% in das Ergebnis mit ein, d. h. die vollständigen 2 pF gehen in das Ergebnis ein. Die feuchteabhängige Komponente mit der Zeitkonstante $\tau$ = 1000 $\Omega$ · 2 pF = 2 $\mu$s als Zeitkonstante des RC-Kreises beeinflusst das Ergebnis hingegen bei einer kürzeren Umladezeit tk2 = 3,3 $\mu$s zu ca. 50% · 2 pF, da der feuchteabhängige Kapazitätswert CF = 2 pF des Kondensators nur zu ca. 50% aufgeladen bzw. umgeladen wird. Die reguläre Komponente der zu messenden Kapazität CM weist eine Zeitkonstante $\tau$ = 20 $\Omega$ · 50 pF = 1 ns auf, wodurch der Messkondensator CM in der kurzen Umladezeit nur vollständig aufgeladen wird, wenn trockene Messbedingungen vorliegen.

Alternativ oder zusätzlich zu der feuchteabhängigen Komponente als möglicher Störgröße, die bei kapazitiven Druckmesszellen auftreten kann, können auch die Anschlusswiderstände bzw. inneren Widerstände zu den Messkondensatoren einer Veränderung unterliegen, was ebenfalls zu einer Verfälschung des Messwertes führt. Auch dies würde sich einfach dadurch äußern, dass die Messergebnisse, d. h. die Periodendauern des Frequenzsignals f zu den beiden Umladezeiten nicht identisch sind.

Die beispielhafte Schaltungsanordnung basiert auf der aus der DE 43 40 472 C1 für sich bekannten Schaltungsanordnung. Bei dieser werden auf den Integrationskondensator der Integrationseinrichtung jeweils zu Beginn eines Auf- bzw. Entladevorganges durch Ankoppeln der zu messenden Kapazität negative bzw. positive Ladungsstöße mit jeweils gleicher Amplitude zu übertragen. Anschließend wird der Integrationskondensator bis zu einer vorgegebenen Referenzschwelle aufgeladen bzw. entladen.

Der wesentliche Vorteil des Verfahrens liegt in der Eliminierung der Störeinflüsse von parallel zum Messkondensator liegenden Widerständen, wodurch sich das Verfahren insbesondere zum Einsatz bei der Kapazitätsmessung von kapazitiven Sensoren, wie zum Beispiel Druckaufnehmern, Temperatursensoren oder dgl. eignet, bei denen nur eine sehr geringe nutzbare Kapazitätsänderung mit hoher Präzision erfasst werden muss. Das Verfahren zeichnet sich dadurch aus, dass bei evtl. zum Messkondensator vorhandenen Parallelwiderständen die Integrationszeitkonstante bei der Aufintegration, also beim Laden des Integrationskondensators, erniedrigt wird und diese Verminderung durch eine Vergrößerung der Integrationszeitkonstanten bei der Abintegration und damit bei der Entladung des Integrationskondensators wieder kompensiert wird.

Im einzelnen kann das aus der DE 43 40 472 C1 bekannte Verfahren anhand folgender Verfahrensschritte durchgeführt werden: Vollständiges Entladen der zu messenden Kapazität, Aufladen der Kapazität auf die halbe Betriebsspannung über den Integrationskondensator der Integrationseinrichtung, Entkoppeln der zu messenden Kapazität von der Integrationseinrichtung und Umladen des Integrationskondensators bis am Ausgang der Integrationseinrichtung eine vorgegebene Referenzspannung anliegt, Anlegen der vollen Betriebsspannung an die Kapazität, und Entladen der Kapazität über die Integrationseinrichtung auf die halbe Betriebsspannung und dadurch Aufladen des Integrationskondensators.

In einer Weiterbildung ist es vorgesehen, die zu messende Kapazität nur zeitweise an die Integrationseinrichtung zu schalten. Vorzugsweise wird die zu messende Kapazität nur jeweils etwa für 0,05 der Taktperiode der sich ergebenden Umladefrequenz des Integrationskondensators an die Integrationseinrichtung geschaltet. Hierdurch können durch Parallelwiderstände verursachte Fehlströme zum Messkondensator den Integrationskondensator nur für einen Bruchteil der Messzeit beeinflussen.

Durch das Verfahren wechseln sich im Takte der Ladungsübertragungen jeweils gleich große positive und negative Ladungsströme am Eingang der Integrationseinrichtung ab. Hierdurch entziehen Fehlströme, die durch parallel zu dem Messkondensator auftretende Widerstände verursacht werden, dem Integrationskondensator in der ersten Hälfte der Messperiode genauso viel Ladungsstrom, wie sie ihm in der zweiten Hälfte zuviel einspeisen.

In einer Weiterbildung der Erfindung ist eine zur zu messenden Kapazität parallel geschaltete Referenzkapazität vorgesehen, die wechselweise zur Messkapazität gemessen wird und zu dieser für den Erhalt eines linearisierten Messwertes in Beziehung gesetzt wird.

Des weiteren kann ein Kompensationskondensator vorgesehen werden, der während des Messvorgangs parallel zum Messkondensator geschaltet wird und in den Zeiten, in denen der Messkondensator entladen ist, an die volle Betriebsspannung gelegt wird. Hierdurch wird die Integrationszeit vermindert und die Empfindlichkeit der gesamten Messanordnung erhöht.

Bei dem in Fig. 1 dargestellten Prinzipschaltbild einer Schaltungsanordnung zur Messung einer Kapazität ist eine Kapazität CM zu messen. Diese Kapazität CM weist einen mit Bezugspotential 10 verbundenen ersten Anschluss A1 und einen zweiten Anschluss A2 auf. Die zu messende Kapazität CM ist über eine Lade-/Entladeeinrichtung LE auf- bzw. entladbar. Die Lade-/Entladeeinrichtung LE weist beispielsweise drei Schalter S1, S3 sowie S6 auf, d.h. einen ersten, einen dritten und einen sechsten Schalter S1, S3 bzw. S6. Der erste Schalter S1 ist parallel zur Kapazität CM geschaltet, während die beiden anderen Schalter S3 und S6 in Reihe zur Kapazität CM geschaltet sind. Der dritte Schalter S3 liegt zwischen der gegenüber dem Bezugspotential 10 vollen Betriebsspannung UB und dem zweiten Anschluss A2 der zu messenden Kapazität CM und der sechste Schalter S6 liegt zwischen diesem zweiten Anschluss A2 und einem Anschluss für die halbe Betriebsspannung 1/2 UB.

Des weiteren ist eine Integrationseinrichtung I mit einem Integrationskondensator CI vorgesehen. Im Blockschaltbild von Fig. 1 weist die Integrationseinrichtung I einen Verstärker V mit einem invertierenden und einem nicht invertierenden Eingang auf. Der Integrationskondensator CI ist zwischen dem invertierenden Eingang und einem Ausgang des Verstärkers, an dem ein Ausgangssignal A abgreifbar ist, geschaltet.

Der invertierende Eingang ist zusätzlich über eine Schalteinrichtung, in diesem Fall einen zweiten Schalter S2, mit dem zweiten Anschluss A2 der zu messenden Kapazität CM verbunden. Der nicht invertierende Eingang des Verstärkers V liegt an der halben Betriebsspannung 1/2 UB. Zusätzlich verfügt die Integrationseinrichtung I über einen Integrationswiderstand RI, der mit einem Anschluss 12 an den invertierenden Eingang des Verstärkers V und damit an den Integrationskondensator CI geschaltet ist. Mit seinem anderen Anschluss 13 liegt der Integrationswiderstand RI dagegen an einer Einrichtung durch welche die Integrationsrichtung, d. h. ein Auf- oder Abintegrieren der Integrationseinrichtung I, festgelegt wird. Diese Einrichtung besteht in der Darstellung von Fig. 1 aus zwei in Reihe geschalteten Schaltern, d.h. einem vierten und einem fünften Schalter S4, S5, deren Reihenschaltung zwischen der Betriebsspannung UB und Bezugspotential 10 liegt. Der vierte Schalter S4 liegt hierbei zwischen dem Anschluss 13 des Integrationswiderstandes RI und einer Klemme für die volle Betriebsspannung UB, während der andere, fünfte Schalter S5 zwischen den Anschluss 13 des Integrationswiderstandes RI und Bezugspotential 10 geschaltet ist.

Schließlich ist der Ausgang des Verstärkers V und damit der Ausgang der Integrationseinrichtung I mit einem Eingang eines Komparators K verbunden, dessen weiterer Eingang mit einer Referenzspannung UR, vorzugsweise wieder der halben Betriebsspannung 1/2 UB, verbunden ist. Ausgangsseitig ist dieser Komparator K mit einer Steuereinrichtung S verbunden, die erste bis sechste Steuersignale v1, v2, v3, v4, v5 und v6 zum Ansteuern der in Fig. 1 dargestellten ersten bis sechsten Schalter S1, S2, S3, S4, S5 bzw. S6 bereitstellt.

Am Ausgang des Komparators K ist ein Frequenzsignal abgreifbar, dessen Frequenz der Umladefrequenz f des Integrationskondensators CI entspricht und eine insbesondere direkte Größe für die zu messende Kapazität CM darstellt.

Das Verfahren zur Messung der Kapazität CM läuft in verschiedenen Phasen ab. Zunächst wird die Kapazität CM zum ersten Zeitpunkt t1 durch Schließen des ersten Schalters S1 vollständig entladen, wobei der zweite, dritte und sechste Schalter S2, S3 bzw. S6 geöffnet sind.

Anschließend wird zum zweiten Zeitpunkt t2 der erste Schalter S1 geöffnet. Zeitgleich oder zu einem dritten Zeitpunkt t3 wird der zweite Schalter S2 kurzzeitig geschlossen. Dadurch lädt sich die zu messende Kapazität CM über die Integrationseinrichtung I auf, wobei davon ausgegangen wird, dass der vierte Schalter S4 geschlossen und der fünfte Schalter S5 geöffnet ist. Dadurch wird die zu messende Kapazität CM auf die halbe Betriebsspannung 1/2 UB über den Integrationskondensator CI der Integrationseinrichtung I aufgeladen. Möglich ist auch das Schließen von dem sechsten Schalter S6 alternativ oder zusätzlich dazu, um die halbe Betriebsspannung UB/2 anzulegen.

Die Schließzeit zum vierten Zeitpunkt t4 des zweiten Schalters S2 wird gerade so bemessen, dass die Aufladung auf die halbe Betriebsspannung UB/2 erfolgen kann. Bei Versuchen hat sich herausgestellt, dass hierfür etwa 0,05 der Taktperiode T ausreicht. Die Zeitspanne, d. h. die erste Umladezeit tk1 kann beispielsweise $10\mu s$ betragen.

Das Aufladen der zu messenden Kapazität CM über den Integrationskondensator bzw. die Integrationskapazität CI führt zum dritten Zeitpunkt t3 zu einem positiven Spannungssprung am Ausgang des integrierenden Verstärkers V. Nach der Aufladung der zu messenden Kapazität CM beträgt deren Ladung

$$Q = CM * UB/2 = CI * \Delta U.$$

Hieraus folgt, dass der Spannungssprung $\Delta U$ am Ausgang des integrierenden Verstärkers V gegeben ist durch

$$\Delta U \;=\; \frac{CM * UB/2}{CI}.$$

Die Umladezeit tk1 wird bestimmt von der Schnelligkeit des integrierenden Verstärkers V und von eventuell vorhandenen Reihenwiderständen. Zu diesen Reihenwiderständen gehört neben den Schaltwiderständen des sechsten und zweiten Schalters S6, S2 auch der Reihenwiderstand RK der zu messenden Kapazität CM.

Sind zur zu messenden Kapazität CM Parallelwiderstände RF vorhanden, wirken sich diese nur während der kurzen Umladezeit, also während der Kopplungszeit tk1, tk2 aus. Ein Parallelwiderstand würde bei der Abintegration in Reihe zum Integrationswiderstand RI liegen und somit die Integrationszeitkonstante der Integrationseinrichtung I vergrößern.

Anschließend wird zum vierten Zeitpunkt t4 der zweite Schalter S2 wieder geöffnet und damit die zu messende Kapazität CM von der Integrationseinrichtung I entkoppelt. Dies führt durch die Stromeinprägung des Integrationswiderstandes RI in den invertierenden Eingang des als Integrator arbeitenden Operationsverstärkers V solange zur Entladung des Integrationskondensators CI, bis am Ausgang A der Integrationseinrichtung I die Referenzspannung UR des Komparators K anliegt.

Zeitgleich zum vierten Schritt oder in einem nächsten, fünften Schritt t5 wird der dritte Schalter S3 über das dritte Schaltsignal v3 geschlossen und die zu messende Kapazität CM somit an die volle Betriebsspannung UB angelegt.

Direkt zum vierten Zeitpunkt oder mit einer anschließenden und durch ein Signal der Steuereinrichtung S vorgegebenen Zeitverzögerung von beispielsweise 0,1μs steuert die Steuereinrichtung S zum fünften Zeitpunkt t5 das dritte Steuersignal v3 auf logisch "1". Daraufhin wird die zu messende Kapazität CM und ggf. eine zusätzliche Referenzkapazität an die volle Betriebsspannung UB gelegt und auf diese aufgeladen.

Ab diesem fünften Zeitpunkt t5 nähert sich das Ausgangssignal A des integrierenden Verstärkers V von oben kommend der Referenzschwelle UR für den Komparator K, wobei die Referenzschwelle UR z. B. der halben Betriebsspannung UB/2 entspricht. Nach der Abkling-Zeitspanne tm, beginnend zum dritten Zeitpunkt t3, reicht die Spannung am Ausgang des Verstärkers V die Referenzschwelle UR. Die Zeitspanne tm berechnet sich gemäß

$$tm \;=\; \frac{CM * UB/2}{CI * UB/2} \;*\; RI \;*\; CI \;=\; CM \;*\; RI.$$

Zu einem sechsten Zeitpunkt t6 ist die Referenzschwelle UR der halben Betriebsspannung UB/2 erreicht, wobei zu diesem Zeitpunkt das Komparatorausgangssignal wieder auf logisch "1" kippt. Da dieses Komparatorausgangssignal der Steuereinrichtung S zugeführt wird, wechselt diese gleichzeitig das dritte Steuersignal v3 auf logisch "0". Aufgrund der Mitkopplungscharakteristik des Komparators K bleibt unmittelbar nach dem sechsten Zeitpunkt t6 das Komparatorausgangssignal auf logisch "1".

Durch die Steuereinrichtung S wird daraufhin zum sechsten Zeitpunkt t6 oder zeitversetzt dazu zu einem siebten Zeitpunkt t7 der zweite Schalter S2 wieder geschlossen, wodurch die zu messende Kapazität CM auf die halbe Betriebsspannung 1/2 UB entladen und dieser Entladungsstoß als negative Ladung auf den Integrationskondensator CI übertragen wird.

Hierfür wird zum siebten Zeitpunkt t7 der zweite Schalter S2 ebenfalls nur kurzzeitig bis zum achten Zeitpunkt t8 geschlossen.

Die Zeitspanne zwischen dem siebten und dem achten Zeitpunkt t7, t8 entspricht wiederum der Umschaltdauer tk1, tk2. Es findet somit eine vom Grundprinzip her gleiche Ladungsübertragung wie vorstehend beschrieben statt, dies jedoch mit umgekehrtem Vorzeichen, so dass jetzt ein negativer Spannungssprung zum siebten Zeitpunkt t7 am Integratorausgang A ansteht.

Der fünfte Schalter S5 wird anschließend geschlossen und der vierte Schalter S4 geöffnet. Hierdurch wird der Integrationskondensator CI über den Integrationswiderstand RI wieder bis zur Referenzspannung UR, vorzugsweise der halben Betriebsspannung 1/2 UB, zurückgeladen.

Anzumerken ist, daß die Schließdauer des zweiten Schalters S2 eine fest vorgegebene Zeitspanne tk1, tk2 ist. Diese Zeitspanne tk1, tk2 hängt nicht vom Ladezustand des Integrationskondensators CI ab. Die Entladezeit des Integrationskondensators CI wird ausschließlich durch das Erreichen der Referenzspannung UR des Komparators K einerseits und die Höhe des Ladungsstoßes, der die zu messende Kapazität CM dem Integrationskondensator CI aufprägt, andererseits bestimmt.

Sowohl die Entladezeit als auch die Aufladezeit des Integrationskondensators CI sind frequenzbestimmend für die Kapazitäts-Frequenzumwandlung der in Fig. 1 dargestellten Schaltungsanordnung.

Wie aus Fig. 1 weiter ersichtlich, kann der nicht mit Bezugspotential 10 verbundene zweite Anschluss A2 der zu messenden Kapazität CM niederohmig zu einem Abgriff 4 nach außen geführt werden. Dieser Anschluss bzw. Abgriff 4 dient als sogenannte "aktive Guard-Leitung", durch die es möglich ist, die Auswerteschaltung bei Hochtemperaturversionen des Messkondensators CM örtlich abzusetzen, ohne dass eine zusätzlich auftretende Leitungskapazität das Messergebnis verfälschen kann. Darüber hinaus kann die Eingangskapazität des integrierenden Verstärkers V das Messergebnis nicht beeinflussen, weil der Eingang des Verstärkers V stets auf konstantem Potential verbleibt.

Zweckmäßigerweise kann die Steuereinrichtung S mit weiteren Komponenten, z. B. einem Taktgeber C zum Bereitstellen eines Systemtakts verbunden sein. Abhängig von dem Taktsignal des Taktgebers C und dem vom Komparator K ausgegebenen Frequenzsignal f gibt die Steuereinrichtung S Steuersignale v1 - v6 für die Schalter S1 - S6 aus.

Anstelle des vierten und des fünften Schalters S4, S5, welche den Integrationswiderstand RI an die Betriebsspannung UB bzw. an die Bezugsspannung 10 anschließen, kann auch eine Integratorschaltung verwendet werden, welche das Ausgangssignal f des Komparators K über einen Inverter an den Integrationswiderstand RI anlegt, wie dies für sich aus der DE 43 40 472 C1 bekannt ist. In diesem Fall wird der positive Eingang des Komparators K zweckmäßigerweise über einen weiteren Kondensator an dessen Ausgang gekoppelt sowie über einen weiteren Widerstand an die Referenzspannung, z. B. die halbe Betriebsspannung UB/2.

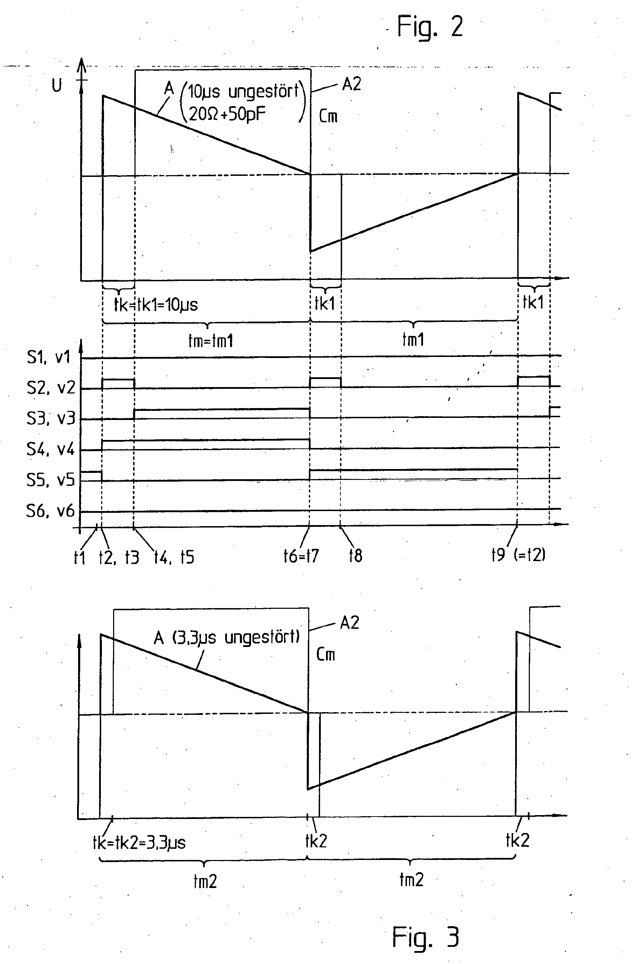

Aus einem Vergleich der Fig. 2 und 3 ist ersichtlich, dass für den Fall einer idealen Messbedingung an der Messzelle mit der zu messenden Kapazität CM unabhängig von der Dauer des ersten oder zweiten Umschaltintervalls zwischen drittem und viertem Zeitpunkt t3, t4 sowie siebtem und achtem Zeitpunkt t7, t8, die bei der ersten bzw. zweiten Umladedauer tk1, tk2 von 10μs bzw. 3,3μs jeweils eine vollständige Aufladung des Integrationskondensators CI erfolgt, so dass die Entladedauer zwischen dem dritten und sechsten bzw. sechsten und neunten Zeitpunkt t3 - t6, t6 - t9 für beide Fälle gleich lang ist. Entsprechend weist auch das Frequenzsignal f am Ausgang des Komparators K eine gleiche Periode T auf.

Außerdem ist in den Fig. 2 und 3 der Spannungszustand der zu messenden Kapazität CM dargestellt, wobei während der Ladedauer tk1 bzw. tk2 ein zentraler Wert am geschlossenen zweiten Schalter S2 liegt.

Dargestellt sind somit die Spannungsverläufe am Messzellenanschluss bzw. der zu messenden Kapazität CM und am Integratorausgang A für die Messzeit von 10μs bzw. von 3,3 μs anhand der Fig. 2 bzw. 3. In beiden Fällen beträgt die Kapazität des Messkondensators 50pF und der in Reihe geschaltete effektive innere Widerstand 20Ω. Es liegen somit ideale Bedingungen vor. Die Messperiodendauer bleibt bei der Messzeit bzw. Ladedauer für beide Umladedauern von 3,3 μs und 10μs konstant, weil der Messkondensator, d. h. die zu messende Kapazität CM, bereits nach 3,3μs vollständig umgeladen ist. Die Steigung der Integratorausgangsspannung am Ausgang A des Integrators I ist konstant und von der zu messenden Kapazität CM unabhängig. Der Spannungssprung am Integratorausgang A ist proportional zu dem Wert der zu messenden Kapazität CM. Der sechste Schalter S6 ist aktiv, wenn von der Messkapazität auf die Referenzkapazität umgeschaltet wird. Folglich ist der sechste Schalter S6 in Fig. 2 stets im geöffneten Zustand.

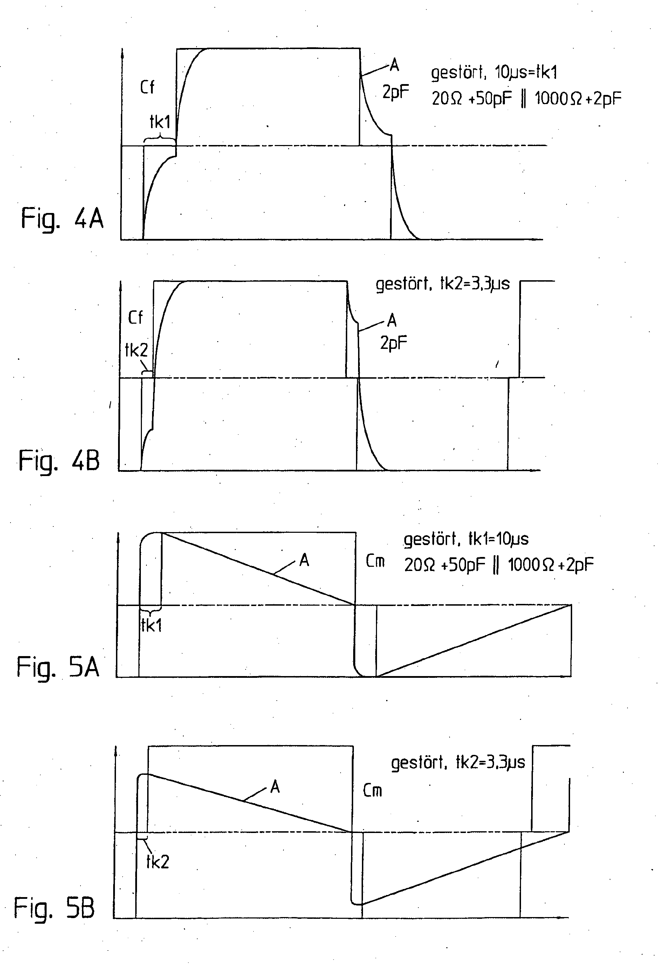

Die Fig. 4A und 4B stellen anschaulich die Spannungsverläufe an der feuchteabhängigen Kapazität CF mit 2pF für die Ladedauer bzw. Umladedauer von 10μs bzw. 3,3μs dar.

Anhand der Fig. 5A und 5B sind die zeitlichen Zustände für den Fall einer nicht idealen Messbedingung, z. B. einer feuchten Umgebung der zu messenden Kapazität CM dargestellt. Bei der langen Umladedauer von 10μs wirkt neben der Kapazität CK von 50pF und dem inneren Widerstand RK von 20Ω zusätzlich parallel die Störkapazität vom CF = 2pF und der Störwiderstand RF von 1000 Ohm. Dies hat zur Folge, dass der parallele Messkondensator nahezu völlig umgeladen wird. Die Folge ist, dass sich die Messperiodendauer verlängert, weil der Integrator I länger braucht, bis er die Referenzspannung UB/2 = UR wieder erreicht hat. Der störende parallele Kondensatorwert CF = 2pF geht über die Umladedauer von tk1 = 10μs komplett in das Ergebnis der Messung mit ein.

Dem hingegen wird, wie dies auf Fig. 5B ersichtlich ist, der parallele Messkondensator bei der kurzen Umladedauer von 3,3μs nur teilweise umgeladen, so dass am Integratorausgang A ein Signal bereitgestellt wird, welches am Ausgang des Komparators K ein Frequenzsignal f mit einer kürzeren Periode ausgibt. Außerdem wird während der Messzeit bzw. Umladedauer tk2 am Ausgang A des Integrators I eine andere Kurvenform erkennbar. Neben der veränderten Periode T bzw. Frequenz des Komparatorausgangsignals f ist auch die Veränderung dieser Kurvenform gegenüber der entsprechenden Kurvenform bei der längeren Umladedauer zum Bestimmen einer den Grundzustand der Kapazität verändernden Messbedingung auswertbar.

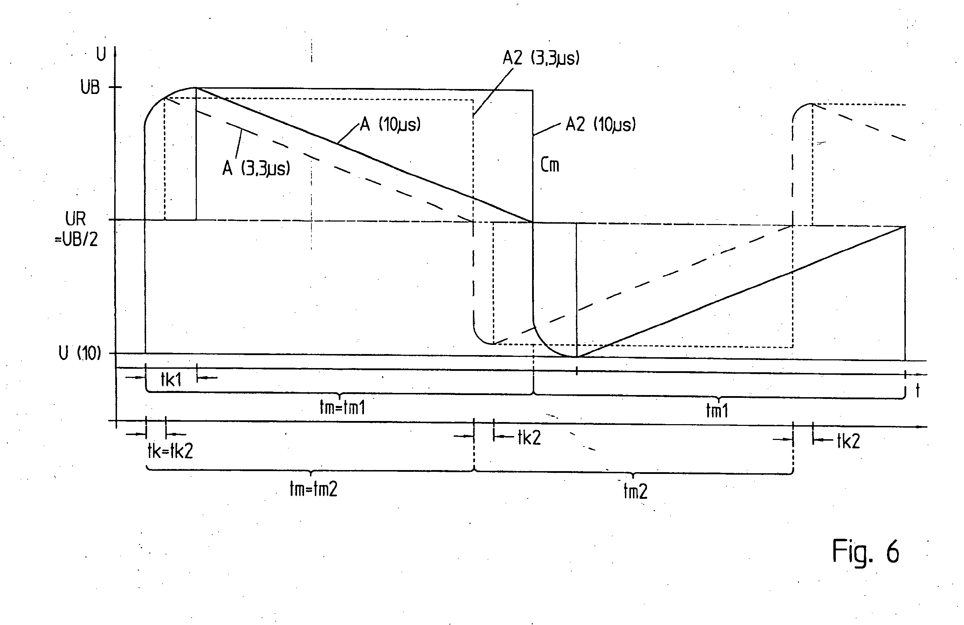

Fig. 6 stellt eine direkte Überlagerung der beiden in den Fig. 5A und 5B zur Veranschaulichung verzerrt dargestellten Kurvenverläufe für eine gestörte zu messende Kapazität CM bei den beiden verschiedenen Umladedauern tk1, tk2 dar. Ersichtlich ist die kürzere Periode für den Fall der kürzeren Umladedauer.

**Patentansprüche**

1. Verfahren zum Auswerten einer Messkapazität (CM) einer Messeinrichtung mit den Schritten:

- Laden der Kapazität (CM) über eine erste Ladedauer (tk1),
- Bestimmen der Ladung der Kapazität als einen ersten Messwert (tm1),
- Laden der Kapazität (CM) über eine zweite Ladedauer (tk2), die verschieden zu der ersten Ladedauer (tk1) ist,
- Bestimmen der Ladung der Kapazität (CM) als einen zweiten Messwert (tm2) und
- Vergleichen des ersten und des zweiten Messwerts (tm1, tm2) miteinander zum Bestimmen eines Vergleichsergebnisses (Δtm) zum Bestimmen einer einen Grundzustand der Kapazität (CM) verändernden Messbedingung, **dadurch gekennzeichnet, dass**

die erste und die zweite Ladedauer (tk1, tk2) so gewählt werden, dass nur bei ausgewählten Meßbedingungen gleiche oder ähnliche Messwerte erzeugt werden, und
die längere Ladedauer (tkl) so ausgewählt wird, dass die Kapazität (CM) sowohl in einer trockenen als auch einer feuchten Umgebung der Kapazität (CM) vollständig oder bis zu einem Mindestladewert aufgeladen wird, und die zweite Ladedauer (tk2) derart ausgewählt wird, dass die Kapazität (CM) nur bei trockener Umgebung der Kapazität (CM) vollständig bzw. bis zu dem Mindestladewert aufgeladen wird.

2. Verfahren nach Anspruch 1, bei dem das Laden der Kapazität (CM) durch ein Umladen von bzw. zu einer anderen Kapazität (CI), insbesondere Integrationskapazität, von einem Referenzspannungswert (UB/2) ausgehend durchgeführt wird.

3. Verfahren nach Anspruch 2, bei dem nach dem Umladen eine lineare Entladung bzw. Rückladung der anderen Kapazität (CI) bis zu dem Referenzspannungswert (UB/2) durchgeführt wird.

4. Verfahren nach Anspruch 2 oder 3, bei dem die Dauer (tm1, tm2) der Entladung bzw. Rückladung als der erste bzw. der zweite Messwert (tm1, tm2) bestimmt wird.

5. Verfahren nach Anspruch 2 oder 3, bei dem die Dauer (tm1, tm2) der Entladung bzw. Rückladung einschließlich der Umladedauer (tk1 bzw. tk2) als der erste bzw. der zweite Messwert (tm1, tm2) bestimmt wird.

6. Verfahren nach einem der Ansprüche 2 bis 5, bei dem die andere Kapazität (CI) in einer Integratorschaltung (I) zum linearen Aufladen bzw. Entladen zu einem Referenzspannungswert (UB/2) hin angeordnet ist.

7. Verfahren nach einem vorstehenden Anspruch, bei dem das Vergleichsergebnis mit einem Toleranzwert verglichen wird.

8. Verfahren nach einem vorstehenden Anspruch, bei dem das Vergleichsergebnis mit vorbestimmbaren Wertebereichen zum Bestimmen eines Änderungsbetrages der Messbedingung verglichen wird.

9. Verfahren nach einem vorstehenden Anspruch, bei dem bei Unter- oder Überschreiten des Vergleichsergebnisses über einen vorbestimmten Grenzwert ein Signal ausgegeben wird, insbesondere eine Korrektur der Messbedingung oder der bestimmten Kapazität veranlasst wird.

10. Verfahren nach einem vorstehenden Anspruch, bei dem eine Differenz der Messwerte (tm1, tm2) zum Bestimmen einer feuchtebedingten Kapazitätsänderung als Messbedingung verwendet wird.

11. Verfahren nach einem vorstehenden Anspruch, bei dem eine Differenz der Messwerte (tm1, tm2) eine Änderung von Innenwiderständen einer Kapazitäts-Ladestrecke anzeigt.

12. Verfahren nach einem vorstehenden Anspruch, bei dem die Kapazität (CM), die mit einem ersten Anschluss (A1) mit Bezugspotential (10) verbunden ist, unter Verwendung einer an eine Betriebsspannung (UB) geschalteten Integrationseinrichtung (I) gemessen wird, wobei der Integrationskondensator (CI) mit einer auf der zu messenden Kapazität (CM) befindlichen Ladung aufgeladen und anschließend wieder entladen wird und die dabei auftretende Umladefrequenz (f) ein Maß für die zu messende Kapazität (CM) darstellt, wobei das Auf- und Entladen des Integrationskondensators (CI) jeweils bis zu einer vorgegebenen Referenzschwelle erfolgt und zu Beginn des Auf- bzw. Entladevorgangs durch Ankoppeln der Kapazität (CM) negative bzw. positive Ladungsstöße, insbesondere mit jeweils gleicher Amplitude, auf den Integrationskondensator (CI) als dem anderen Kondensator übertragen werden.

**Claims**

1. A method of evaluating the measuring capacity (CM) of a measuring instrument with the steps:

   - charging the capacity (CM) over a first charging duration (tk1),
   - determining the charge of the capacity as a first measurement value (tm1)
   - charging the capacity (CM) over a second charging duration (tk2) which is different from the first charging duration (tk1),
   - determining the charge of the capacity (CM) as a second measurement value (tm2) and
   - comparing the first and the second measurement values (tm1, tm2) with each other in order to determine a comparison result (Δtm) to determine a measurement condition which changes a basic state of the capacity (CM), **characterized in that** the first and the second charging durations (tk1, tk2) are selected in such a way that the same or similar measurement values are produced only under selected measurement conditions, and

   the longer charging duration (tk1) is selected in such a way that the capacity (CM) is charged completely or up to a minimum charging value both in a dry environment and in a damp environment of the capacity (CM), and the second charging duration (tk2) is selected in such a way that the capacity (CM) is charged completely or up to the minimum charging value only in a dry environment of the capacity (CM).

2. A method according to claim 1, in which the charging of the capacity (CM) is carried out by the recharging of or to another capacity (CI), in particular an integration capacity, starting from a reference voltage value (UB/2).

3. A method according to claim 2, in which after the recharging a linear discharging or back charging of the other capacity (CI) is carried out until the reference voltage value (UB/2).

4. A method according to claim 2 or 3, in which the duration (tm1, tm2) of the discharging or back charging is determined as the first and the second measurement values (tm1, tm2) respectively.

5. A method according to claim 2 or 3, in which the duration (tm1, tm2) of the discharging or back charging including the recharging duration (tk1 and tk2 respectively) is determined as the first and the second measurement values (tm1, tm2) respectively.

6. A method according to any one of claims 2 to 5, in which the other capacity (CI) is present in an integrator circuit (I) for the linear charging or discharging towards a reference voltage value (UB/2).

7. A method according to a preceding claim, in which the comparison result is compared with a tolerance value.

8. A method according to a preceding claim, in which the comparison result is compared with value ranges capable of being pre-determined in order to determine an amount of change of the measuring condition.

9. A method according to a preceding claim, in which if the comparison result is not reached or is exceeded over a pre-determined boundary value a signal is emitted, in particular a correction of the measuring condition or the determined capacity.

10. A method according to a preceding claim, in which a difference of the measurement values (tm1, tm2) is used as a measuring condition to determine a capacity change caused by dampness.

11. A method according to a preceding claim, in which a difference of the measurement values (tm1, tm2) indicates a change of internal resistances of a capacity charge path.

12. A method according to a preceding claim, in which the capacity (CM), which is connected to a first terminal (A1) with a reference potential (10), is measured using an integration device (I) switched to an operating voltage (UB), wherein the integration capacitor (CI) is charged with a charge present at the capacity (CM) to be measured and is then discharged again, and the recharging frequency (f) occurring in this case represents a measure of the capacity (CM) to be measured, wherein the charging and discharging of the integration capacitor (CI) is carried out in each case up to a pre-set reference threshold, and at the beginning of the charging and discharging procedure negative and positive charge bursts, in particular at the same amplitude in each case, are transmitted to the integration capacitor (CI) as the other capacitor by coupling the capacity (CM).

**Revendications**

1. Procédé permettant d'évaluer une capacité de mesure (CM) d'un dispositif de mesure comportant les étapes consistant à :

   - charger la capacité (CM) pendant une première durée de charge (tk1),
   - déterminer la charge de cette capacité entant que première valeur de mesure (tm1),
   - charger la capacité (CM) pendant une seconde durée de charge (tk2) qui est différente de la première durée de charge (tk1),
   - déterminer la charge de cette capacité (CM) entant que seconde valeur de mesure (tm2), et
   - comparer la première et la seconde valeur de mesure (tm1, tm2) pour déterminer un résultat de comparaison (Δtm) permettant de déterminer une condition de mesure modifiant l'état de base de la capacité (CM),

   **caractérisé en ce que**
   la première et la seconde durée de charge (tk1, tk2) sont choisies de sorte que l'on n'obtienne de valeurs de mesure égales ou similaires, que dans des conditions de mesure sélectionnées et, la durée de charge la plus longue (tk1) est choisie de sorte que la capacité (CM) soit chargée en totalité ou jusqu'à une valeur de charge minimum aussi bien dans un environnement sec que dans un environnement humide de cette capacité (CM), et la seconde durée de charge (tk2) est choisie de sorte que la capacité (CM) ne soit chargée en totalité ou jusqu'à la valeur de charge minimum que dans un environnement sec de cette capacité (CM).

2. Procédé conforme à la revendication 1, selon lequel la charge de la capacité (CM) est effectuée par un transfert de charge à partir ou vers un autre condensateur (CI), en particulier un condensateur d'intégration à partir d'une valeur de tension de référence (UB/2).

3. Procédé conforme à la revendication 2, selon lequel après le transfert de charge, on effectue une décharge ou une recharge linéaire de l'autre condensateur (CI) jusqu'à la valeur de tension de référence (UB/2).

4. Procédé conforme à la revendication 2 ou 3, selon lequel la durée (tm1, tm2) de la décharge ou de la recharge est définie comme étant la première ou la seconde valeur de mesure (tm1, tm2).

5. Procédé conforme à la revendication 2 ou 3, selon lequel la durée (tm1, tm2) de la décharge ou de la recharge y compris la durée de transfert de charge (tk1 ou tk2) est définie comme étant la première ou la seconde valeur de mesure (tm1, tm2).

6. Procédé conforme à l'une des revendications 2 à 5, selon lequel l'autre condensateur (CI) est monté dans un circuit intégrateur (I) pour permettre la charge ou le décharge linéaire jusqu'à une valeur de tension de référence (UB/2).

7. Procédé conforme à l'une des revendications précédentes, selon lequel le résultat de comparaison est comparé à une valeur de tolérance.

8. Procédé conforme à l'une des revendications précédentes,
   **caractérisé en ce que**
   le résultat de comparaison est comparé à des plages de valeurs pouvant être prédéfinies pour permettre de déterminer l'importance de la variation de la condition de mesure.

9. Procédé conforme à l'une des revendications précédentes, selon lequel en présence d'un dépassement vers le bas ou vers le haut du résultat de comparaison au-delà d'une limite prédéfinie, un signal est délivré, et en particulier une correction de la condition de mesure ou de la capacité évaluée est autorisée.

10. Procédé conforme à l'une des revendications précédentes, selon lequel on utilise une différence des valeurs de mesure (tm1, tm2) pour déterminer une modification de la capacité liée à l'humidité entant que condition de mesure.

11. Procédé conforme à l'une des revendications précédentes, selon lequel une différence des valeurs de mesure (tm1, tm2) montre une modification des résistances internes de la voie de charge de la capacité.

12. Procédé conforme à l'une des revendications précédentes, selon lequel la capacité (CM) qui est reliée à une première borne (A1) ayant un potentiel de référence (10) est mesurée en utilisant un dispositif d'intégration (I) branché sur une tension de fonctionnement (UB), le condensateur d'intégration (CI) étant chargé avec une charge situé sur la capacité (CM) à mesurer puis à nouveau déchargé, et la fréquence de transfert de charge (I) ainsi obtenue représentant une mesure de la capacité (CM) à mesurer, la charge et la décharge du condensateur d'intégration (CI) étant à chaque fois effectuée jusqu'à un seuil de référence prédéfini, et, au début du processus de charge ou de décharge, des chocs de charge négatifs ou positifs en particulier ayant à chaque fois la même amplitude étant transférés sur le condensateur d'intégration (CI) constituant l'autre condensateur par couplage de la capacité (CM).

Fig. 1

EP 1 500 940 B1

## Fig. 2

A (10µs ungestört) (20Ω+50pF) — A2 Cm

tk=tk1=10µs  tk1  tk1

tm=tm1  tm1

S1, v1
S2, v2
S3, v3
S4, v4
S5, v5
S6, v6

t1  t2, t3  t4, t5  t6=t7  t8  t9 (=t2)

A (3,3µs ungestört) — A2 Cm

tk=tk2=3,3µs  tk2  tk2

tm2  tm2

## Fig. 3

Fig. 4A

gestört, 10µs=tk1
20Ω +50pF ∥ 1000Ω +2pF

Fig. 4B

gestört, tk2=3,3µs

Fig. 5A

gestört, tk1=10µs
20Ω +50pF ∥ 1000Ω +2pF

Fig. 5B

gestört, tk2=3,3µs

Fig. 6

A2 (3,3µs)

A2 (10µs)

Cm

A (10µs)

A (3,3µs)

U

UB

UR =UB/2

U (10)

tm1

tm2

tk2

tk2

tm=tm1

tm=tm2

tk1

tk=tk2

t

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3413849 A1
- DE 3544187 A1
- DE 4237196 C1
- DE 4340472 C1
- WO 0104648 A1
- EP 1411349 A1